# EUROPÄISCHE PATENTSCHRIFT

(11) **EP 3 798 193 B1**
(45) Veröffentlichungstag und Bekanntmachung des Hinweises auf die Patenterteilung: **16.08.2023**
(21) Anmeldenummer: 20192282.0
(22) Anmeldetag: 21.08.2020
(51) Int. Cl.: C03C 17/00, B65G 37/00, B65G 49/00, C23C 16/02, C23C 16/44, C23C 16/04, C23C 16/54, C23C 16/50

(54) **VORRICHTUNG ZUM BESCHICHTEN VON BEHÄLTNISSEN MIT BYPASS UND VERFAHREN ZUM BETREIBEN EINER SOLCHEN VORRICHTUNG**
DEVICE FOR COATING CONTAINERS WITH BYPASS AND METHOD FOR OPERATING SUCH A DEVICE
DISPOSITIF DE REVÊTEMENT DES RÉCIPIENTS POURVU DE DÉRIVATION ET PROCÉDÉ DE FONCTIONNEMENT D'UN TEL DISPOSITIF

(30) Priorität: 30.09.2019 DE 102019126291
(43) Veröffentlichungstag der Anmeldung: 31.03.2021
(73) Patentinhaber: Krones AG, 93073 Neutraubling (DE)
(72) Erfinder: Kammerl, Martin, 93073 Neutraubling (DE); Neubauer, Michael, 93073 Neutraubling (DE); Voth, Klaus, 93073 Neutraubling (DE)
(74) Vertreter: Bittner, Bernhard

(56) Entgegenhaltungen:
- WO-A1-2017/162509
- WO-A2-2015/036196
- DE-A1-102013 112 091

## Beschreibung

Die vorliegende Erfindung betrifft eine Vorrichtung und ein Verfahren gemäß den Oberbegriffen der Patentansprüche 1 und 6.

Zur Verminderung der Durchlässigkeit von Behältnissen, insbesondere von Kunststoffbehältnissen, z.B. in Bezug auf unerwünschte Stoffe, ist es vorteilhaft, diese mit einer Barriereschicht zu beschichten. Die Beschichtung kann dabei insbesondere mithilfe einer Plasmabehandlung erfolgen. Daher ist es üblich, in Anlagen, die Behältnisse herstellen und/oder behandeln, eine Beschichtungsvorrichtung vorzusehen, in der die Behältnisse beschichtet werden können.

Dabei ist es jedoch denkbar, dass auch Behältnisse hergestellt und/oder behandelt werden sollen, die nicht beschichtet werden sollen. Insbesondere kann es auch erwünscht sein, dass an der Beschichtungsanlage eine Wartung durchgeführt werden kann, während Behältnisse ohne Beschichtung hergestellt und/oder behandelt werden. Dies ist bei bekannten Beschichtungsanlagen nicht oder nur schwer während des Produktionsbetriebs möglich.

Aus der WO 2017/162509 A1 ist dabei eine Vorrichtung und ein Verfahren zur Plasmabeschichtung von Behältnissen mit mehreren Plasmastationen 3 bekannt, wobei die Plasmastationen jeweils mindestens eine Bypassleitung aufweisen, so dass bei einer Betriebsstörung und/oder Ausblendung wenigstens einer der Behandlungsplätze der Plasmastation das Prozessgas vor dessen Zuführung in die Plasmakammer und/oder an den Behandlungsplatz mittels der einen oder mehreren Bypassleitungen ableitbar ist.

Der Erfindung liegt daher die Aufgabe zugrunde, eine Vorrichtung und ein Verfahren zur Verfügung zu stellen, bei der ein Produktionsbetrieb möglich ist ohne, dass die Behältnisse von der Beschichtungsvorrichtung behandelt werden. Insbesondere soll auch eine einfache Wartung der Beschichtungsvorrichtung während des Produktionsbetriebs ermöglicht werden.

Eine erfindungsgemäße Vorrichtung zum Beschichten von Behältnissen weist einen Einlauf, an dem der Vorrichtung Behältnisse übergeben werden, und einem Auslauf, an dem die Behältnisse die Vorrichtung verlassen, auf. Die Vorrichtung weist außerdem wenigstens eine Vakuumvorrichtung zur Erzeugung eines Vakuums und wenigstens eine Behandlungsstation zum Beschichten von Behältnissen mit einem Plasma auf, wobei die Behandlungsstation in einer Fluidverbindung mit der Vakuumvorrichtung steht und wobei die Behandlungsstation wenigstens eine Behandlungseinrichtung aufweist, die in ein Behältnis einführbar ist. Die Vorrichtung weist außerdem eine erste und eine zweite Transporteinrichtung zum Transportieren von Behältnissen auf, wobei die erste Transporteinrichtung die Behältnisse zumindest mittelbar einer Behandlungsstation zuführt.

Erfindungsgemäß ist die erste Transporteinrichtung abschaltbar, so dass die Zuführung von Behältnissen an die Behandlungsstation unterbrochen ist, und es sich bei der zweiten Transporteinrichtung um eine wenigstens abschnittsweise lineare Transporteinrichtung handelt, welche dazu geeignet ist, die Behältnisse auch bei einer abgeschalteten ersten Transporteinrichtung vom Einlauf zum Auslauf zu transportieren.

Hierdurch wird ermöglicht, dass eine Produktion auch dann weiter betrieben werden kann, wenn die Behältnisse nicht beschichtet werden sollen. Es ist somit möglich, die Behandlungsstation, in der die Behältnisse beschichtet werden, abzuschalten und dennoch Behältnisse weiter zu transportieren. Somit kann beispielsweise besonders einfach eine Wartung an Teilen durchgeführt werden, die sich während eines Produktionsbetriebs mit Beschichtung üblicherweise bewegen. Beispielsweise kann hierdurch sichergestellt werden, dass sich drehende Träger, denen eine oder mehrere Behandlungsstationen zur Beschichtung zugeordnet sind, nicht weiterdrehen. Es wird somit vorgeschlagen, Behältnisse an der Vorrichtung zum Beschichten von Behältnissen mittels eines Bypasses vorbeizuführen.

Bei den Behältnissen kann es sich um Vorformlinge, Flaschen, Dosen, KEGS, Spritzen, Pouches oder dergleichen handeln. Diese können aus verschiedenen Materialien, wie beispielsweise Kunststoff, Glas, Metall, etc. bestehen. Besonders bevorzugt ist die Vorrichtung für ein Beschichten von Kunststoffflaschen vorgesehen.

Bei einer vorteilhaften Ausführungsform ist die zweite Transporteinrichtung eine Wendeeinrichtung zum Wenden der Behältnisse. Unter einem Wenden der Behältnisse ist dabei zu verstehen, dass die Behältnisse von einer aufrechtstehenden Position in eine umgedrehte Position umgedreht werden und/oder von einer umgedrehten Position in eine aufrechtstehende Position. Als aufrechtstehende Position ist eine Position des Behältnisses anzusehen, bei der ein Boden des Behältnisses nach unten und/oder eine Behälteröffnung des Behältnisses nach oben zeigt, wobei die Richtungsangaben jeweils in Bezug auf die Schwerkraft zu verstehen sind. Als umgedrehte Position ist eine Position des Behältnisses anzusehen, bei der ein Boden des Behältnisses nach oben und/oder eine Behälteröffnung des Behältnisses nach unten zeigt. Bei der umgedrehten Position handelt es sich insbesondere um eine zur aufrechtstehenden Position um 180° gedrehte Position.

Bei einer bevorzugten Ausführungsform ist die zweite Transporteinrichtung umlaufend ausgebildet. Bevorzugt weist die zweite Transporteinrichtung einen linearen Abschnitt auf, entlang dem die Behältnisse einen linearen Transportpfad entlang bewegt werden können. Vorteilhaft weist die Transporteinrichtung auch wenigstens einen, bevorzugt zwei, gekrümmte Abschnitte auf. Vorteilhaft sind der lineare und der bzw. die gekrümmten Abschnitte in einer Ebene zueinander angeordnet, die in etwa durch den Erdmittelpunkt verlaufen würde, also in einer Ebene, die im Wesentlichen senkrecht zu einer horizontalen Ebene steht. Vorteilhaft führen die gekrümmten Abschnitte somit (bezogen auf die Schwerkraft) nach unten bzw. oben.

Bevorzugt ist die zweite Transporteinrichtung so ausgestaltet, dass die Behältnisse sowohl den linearen Abschnitt entlang bewegt werden können als auch mindestens einen gekrümmten Abschnitt, besonders bevorzugt zwei gekrümmte Abschnitte. Vorteilhaft können die Behältnisse auf der zweiten Transporteinrichtung gewendet werden, indem sie einen gekrümmten Abschnitt entlang transportiert werden.

Es sind jedoch auch andere Formen von Wendevorgänge denkbar. Beispielsweise könnte die Transporteinrichtung auch Klammern aufweisen, die gedreht werden können. Vorteilhaft kann ein Wendevorgang auch während des Transports auf einem linearen Transportpfad erfolgen.

Bei einer vorteilhaften Ausführungsform handelt es sich bei der ersten und/oder zweiten Transporteinrichtung um eine kontinuierlich arbeitende Transporteinrichtung, also um eine Transporteinrichtung, welche die Behältnisse kontinuierlich transportiert. Bei einer vorteilhaften Ausführungsform werden die Behältnisse dabei mit einer gleichbleibenden Geschwindigkeit transportiert. Bei einer vorteilhaften Ausführungsform kann unter einem kontinuierlichen Transport jedoch auch verstanden werden, dass die Behältnisse mit veränderlicher Geschwindigkeit transportiert werden. Insbesondere ist es auch möglich, dass einzelne Behältnisse beschleunigt oder abgebremst werden.

Bei einer weiteren vorteilhaften Ausführungsform kann in der Vorrichtung zumindest abschnittsweise ein getakteter Transport und/oder eine getaktete Behandlung vorgesehen sein. Bevorzugt kann insbesondere der Beschichtungsvorgang getaktet stattfinden.

Bei einer bevorzugten Ausführungsform ist die erste und/oder zweite Transporteinrichtung derart gestaltet, dass sie die Kunststoffvorformlinge in einer vorgegebenen und insbesondere auch einheitlichen Ausrichtung bezogen auf deren Längsachse transportiert. Vorteilhaft weist die Transporteinrichtung eine Vielzahl von Transporteinheiten zum Transportieren von je einem Behältnis auf. Vorteilhaft kann es sich bei den Transporteinheiten um Haltevorrichtungen o. ä. handeln, die die zu transportierenden Behältnisse aufnehmen. Bevorzugt handelt es sich um Greifer, wie beispielsweise Neckhandlingklammern, die die Behältnisse greifen.

Bei einer vorteilhaften Ausführungsform sind die Transporteinheiten der ersten und/oder zweiten Transporteinrichtung in einer Reihe hintereinander angeordnet. Vorteilhaft ist somit die erste und/oder zweite Transporteinrichtung dazu geeignet, die Behältnisse in einer Reihe, insbesondere einspurig, zu transportierten.

Bei einer vorteilhaften Ausführungsform weist die zweite Transporteinrichtung einen Langstator Linearmotor auf. Vorteilhaft ermöglicht die zweite Transporteinrichtung einen Individualtransport der Behältnisse. Vorteilhaft ist die zweite Transporteinrichtung dazu geeignet, die Geschwindigkeit einzelner Behältnisse zu variieren. Besonders vorteilhaft ist die zweite Transporteinrichtung dazu geeignet den Abstand zwischen einzelnen Behältnissen (sog. Teilung) zu verändern.

Bei einer vorteilhaften Ausführungsform ist stromaufwärts und/oder stromabwärts der zweiten Transporteinrichtung ein Transferstern angeordnet. Besonders bevorzugt ist ein stromaufwärts angeordneter Transferstern dazu geeignet, die Behältnisse an die zweite Transporteinrichtung zu übergeben und ein stromabwärts angeordneter Transferstern dazu geeignet, dass die Behältnisse von der zweiten Transporteinrichtung an ihn übergeben werden. Unter dem Begriff der Übergabe ist im Rahmen dieser Erfindung lediglich ein Wechsel des Behältnisses von einer Vorrichtung zur nächsten zu verstehen. Der Begriff soll somit insbesondere eine aktive Entnahme durch eine Vorrichtung als auch eine passive Annahme durch eine Vorrichtung umfassen. Bei dem Transfernstern kann es sich grundsätzlich um einen Teilungsverzugsstern handeln. Besonders bevorzugt handelt es sich jedoch um einen gewöhnlichen Transfernstern, der die Teilung nicht verändert.

Bei einer alternativen Ausführungsform handelt es sich bei der zweiten Transporteinrichtung um ein ketten- oder riemenbasiertes System. Vorteilhaft werden die Behältnisse auch bei dieser Ausführungsform vereinzelt mittels einer Vielzahl von Transporteinheiten transportiert. Bei dieser Ausführungsform werden die Behältnisse von der zweiten Transporteinrichtung bevorzugt mit einer gleichbleibenden Geschwindigkeit transportiert, ohne dass die Abstände zwischen den einzelnen Behältnissen variiert werden.

Besonders vorteilhaft ist bei dieser alternativen Ausführungsform stromaufwärts und/oder stromabwärts der zweiten Transporteinrichtung ein Teilungsverzugsstern angeordnet, der die Abstände zwischen den Behältnissen verändern kann.

Für die erste Transporteinrichtung kann ebenfalls eine zumindest abschnittsweise lineare Transporteinrichtung, insbesondere ein Transportband, eine Transportkette oder ein Individualtransport mittels Linearmotor, verwendet werden. Bei der Transporteinrichtung kann es sich somit z. B. um ein ketten- oder riemenbasiertes System handeln. Besonders vorteilhaft wäre auch hier der Einsatz eines Langstator Linearmotorsystems denkbar.

Bei einer vorteilhaften Ausführungsform besteht zwischen der ersten und der zweiten Transporteinrichtung ein Übergabepunkt, an dem Behältnisse von der ersten an die zweite und/oder von der zweiten an die erste Transporteinrichtung übergebbar sind. Bei einer besonders bevorzugten Ausführungsform sind an dem Übergabepunkt Behältnisse von der zweiten an die erste Transporteinrichtung übergebbar und an dem im Wesentlichen gleichen Übergabepunkt Behältnisse von der ersten an die zweite Transporteinrichtung. Unter "im Wesentlichen" ist dabei zu verstehen, dass auch Ausführungsformen umfasst sein sollen, bei denen die Übergabe leicht versetzt voneinander stattfindet.

Vorteilhaft sind die erste und die zweite Transporteinrichtung so zueinander angeordnet, dass die Behältnisse erst ein Stück von der zweiten Transporteinrichtung transportiert werden können, dann am Übergabepunkt an die erste Transporteinrichtung übergeben, von der ersten Transporteinrichtung transportiert und anschließend am Übergabepunkt wieder an die zweite Transporteinrichtung übergeben und von dieser weiter transportiert werden können.

Vorteilhaft ist der Übergabepunkt zumindest zeitweise deaktivierbar, so dass die Behältnisse bei deaktiviertem Übergabepunkt nicht an die erste Transporteinrichtung übergeben werden, sondern auf der zweiten Transporteinrichtung verbleiben und von dieser weiter transportiert werden können.

Besonders bevorzugt können die Behältnisse von der zweiten Transporteinrichtung zunächst einen gekrümmten Abschnitt entlang geführt werden, so dass ein Wenden der Behältnisse erfolgt. Bevorzugt ist die zweite Transporteinrichtung derart ausgestaltet, dass die Behältnisse zunächst aufrechtstehend übernommen werden können und durch den gekrümmten Abschnitt in eine umgedrehte Position gewendet werden können. Bevorzugt liegt der Übergabepunkt im Bereich des linearen Abschnitts. Vorteilhaft liegt der Übergabepunkt in einem Bereich, in dem die Behältnisse in einer umgedrehten Position mit der Öffnung nach unten transportiert werden. Bevorzugt ist die zweite Transporteinrichtung derart ausgestaltet, dass die Behältnisse nach dem Übergabepunkt erneut einen gekrümmten Abschnitt entlang transportiert werden und dabei wieder in eine aufrechtstehende Position gewendet werden.

Erfindungsgemäß umfasst die Vorrichtung wenigstens zwei Handhabungsvorrichtungen zur Übergabe einer vordefinierten Anzahl von Behältnissen von der ersten Transporteinrichtung in einem Übergabebereich und zur Abgabe dieser Behältnisse an die erste Transporteinrichtung in einem Abgabebereich wobei die Handhabungsvorrichtungen jeweils einen beweglichen Träger aufweisen, mit dem die entnommenen Behältnisse auf einem Transportpfad bewegt werden können, und wobei den Handhabungsvorrichtungen jeweils wenigstens eine Behandlungsstation zugeordnet ist.

Vorteilhaft ist die Transportgeschwindigkeit der Handhabungsvorrichtung nach der Übergabe der Behältnisse reduzierbar. Unter dem Begriff der "Transportgeschwindigkeit" ist dabei die Geschwindigkeit zu verstehen, mit der Behältnisse entlang eines Transportpfads bewegt werden. Bevorzugt ist die Geschwindigkeit der Behältnisse im Bereich der Behandlungsstationen bis zum Stillstand der Behältnisse reduzierbar.

Bei einer bevorzugten Ausführungsform werden ein oder mehrere Behältnisse an eine Handhabungsvorrichtung übergeben, während die anderen Behältnisse von der Transporteinrichtung weitertransportiert werden. Vorteilhaft werden die weitertransportierten Behältnisse an eine weitere Handhabungsvorrichtung übergeben.

Bevorzugt sind jeder Handhabungsvorrichtung mehrere, insbesondere stationäre, Behandlungsstationen zugewiesen. Vorteilhaft weist jede Handhabungsvorrichtung mindestens die Anzahl an Behandlungsstationen auf, die der vordefinierten Anzahl von Behältnissen entspricht, die der Handhabungsvorrichtung in einem Zyklus am Übergabepunkt übergeben werden.

Bei einer bevorzugten Ausführungsform sind der Übergabebereich und der Abgabebereich einer Handhabungsvorrichtung nicht räumlich voneinander getrennt angeordnet, sondern es stimmt der Abgabebereich einer Handhabungsvorrichtung mit dem Übergabebereich einer Handhabungsvorrichtung räumlich überein. Vorteilhaft ist die Handhabungsvorrichtung somit dafür geeignet, im gleichen Bereich Behältnisse aufzunehmen bzw. abzugeben. Besonders bevorzugt ist die Handhabungsvorrichtung dazu geeignet, abwechselnd Behältnisse aufzunehmen und abzugeben.

Bei einer bevorzugten Ausführungsform ist während eines Produktionsbetriebs nicht jede Transporteinheit mit einem Behältnis besetzt. Besonders bevorzugt ist die Vorrichtung so ausgestaltet, dass nur jede zweite Transporteinheit mit einem Behältnis besetzt wird. Bei einer vorteilhaften Ausführungsform sind die besetzten und unbesetzten Transporteinheiten grundsätzlich identisch ausgestaltet.

Vorteilhaft ist die Vorrichtung dazu geeignet, dass in der zweiten Transporteinrichtung die Behältnisse zunächst von jeder zweiten Transporteinheit (zur Unterscheidung als A-Klammer bezeichnet) transportiert werden können und am Übergabepunkt eine Übergabe an jede zweite Transporteinheit (zur Unterscheidung auch hier als A-Klammer bezeichnet) der ersten Transporteinrichtung übergeben werden. Bevorzugt können die Behältnisse von den A-Klammern an die Handhabungsvorrichtung übergeben und in Behandlungsstationen beschichtet werden und anschließend an die jeweils versetzen (zur Unterscheidung als B-Klammer bezeichnet) Transporteinheiten der ersten Transporteinrichtung wieder übergeben werden. Vorteilhaft ist die Vorrichtung so ausgestaltet, dass die Behältnisse von diesen B-Klammern der ersten Transporteinrichtung an die B-Klammern der zweiten Transporteinrichtung übergeben werden können, also an exakt die Transporteinheiten, die zuvor unbesetzt waren.

Es wird somit vorgeschlagen, dass die Vorrichtung vorteilhaft so ausgestaltet ist, dass die zweite Transporteinrichtung dazu geeignet ist, die Behältnisse vor dem Übergabepunkt mit Transporteinheiten zu transportieren, die jeweils um eine Transporteinheit versetzt angeordnet sind zu den Transporteinheiten, die die Behältnisse nach dem Übergabepunkt transportieren, sofern die Behältnisse an die erste Transporteinrichtung übergeben worden sind. Bei einer vorteilhaften Ausführungsform ist die Vorrichtung so ausgestaltet, dass die Behältnisse bei einem deaktivierten Übergabepunkt auch nach dem Übergabepunkt von der zweiten Transporteinrichtung von den gleichen Transporteinheiten weitertransportiert werden können wie vor dem Übergabepunkt. Es wird somit vorgeschlagen, dass die Vorrichtung so gestaltet ist, dass die Behältnisse auf der zweiten Transporteinrichtung zuerst von A-Klammern transportiert werden können und ab dem Übergabepunkt entweder - sofern eine Beschichtung durchgeführt werden soll - auf den B-Klammern transportiert werden können oder - sofern keine Beschichtung durchgeführt werden soll - auf den A-Klammern weitertransportiert werden können.

Die vorliegende Erfindung ist weiterhin auf eine Anlage zum Herstellen und/oder Behandeln von Behältnissen mit einer Vorrichtung der oben beschriebenen Art gerichtet. Diese Anlage weist vorteilhaft außerdem (weitere) Vorrichtungen zum Herstellen und/oder Behandeln von Behältnissen auf. Vorteilhaft sind die einzelnen Vorrichtungen der Anlage über Transporteinrichtungen verbunden, so dass die herzustellenden und/oder zu behandelnden Behältnisse von einer Vorrichtung zur nächsten transportiert werden können.

Bevorzugt ist in der Anlage stromaufwärts zur Vorrichtung zum Beschichten von Behältnissen eine Umformungseinrichtung zum Umformen von Kunststoffvorformlingen zu Kunststoffbehältnissen vorgesehen. Dabei kann es sich vorteilhaft um eine Blasformmaschine handeln. Vorteilhaft ist stromaufwärts zur Umformungseinrichtung eine Erwärmungseinrichtung angeordnet.

Vorteilhaft ist stromabwärts zur Vorrichtung zum Beschichten von Behältnissen wenigstens eine Reinigungsvorrichtung vorgesehen. Dabei kann es sich bevorzugt um einen Rinser und/oder eine Sterilisationseinrichtung handeln. Vorteilhaft ist stromabwärts zur Vorrichtung zum Beschichten von Behältnissen eine Fülleinrichtung vorgesehen, welche die Behältnisse insbesondere mit einer Flüssigkeit, insbesondere mit einem Getränk befüllt. Vorteilhaft sind stromabwärts zur Fülleinrichtung weitere Vorrichtungen vorgesehen wie beispielsweise ein Verschließer und/oder eine Trocknungsstation und/oder eine Etikettiereinrichtung und/oder eine Verpackungsvorrichtung wie ein Palettierer.

Vorteilhaft kann die Teilung der stromabwärts angeordneten Vorrichtungen elektronisch versetzt werden. Insbesondere kann die Teilung in Abhängigkeit davon versetzt werden, ob eine Beschichtung durchgeführt wird oder nicht.

Werden in dem oben beschriebenen Ausführungsbeispiel die Behältnisse zunächst von A-Klammern transportiert, werden die Behältnisse, wenn eine Beschichtung stattfand und sie im Zuge dessen von den A-Klammern entfernt und anschließend an B-Klammern übergeben wurden, am Auslauf der Vorrichtung zum Beschichten von Behältnissen von B-Klammern transportiert. Die Teilung der stromabwärts angeordneten Vorrichtungen muss demnach entsprechend eingestellt sein, dass Behältnisse von B-Klammern übernommen und entsprechen weiterbehandelt werden. Werden die Behältnisse in dem beschriebenen Ausführungsbeispiel dagegen nicht beschichtet und bleiben daher bis zum Auslauf der Vorrichtung zum Beschichten von Behältnissen auf A-Klammern, muss die Teilung der stromabwärts angeordneten Vorrichtungen entsprechend eingestellt sein, dass Behältnisse von A-Klammern übernommen und entsprechen weiterbehandelt werden.

Bei einer vorteilhaften Ausführungsform weist die Anlage einen Servoantrieb auf. Bevorzugt kann mit diesem Servoantrieb die Teilung des Produktionsstroms ab einem bestimmten Ort elektronisch versetzt werden. Besonders bevorzugt ermöglicht es der Servoantrieb, die Vorrichtungen, die stromabwärts zum Auslauf der Vorrichtung zum Beschichten von Behältnissen angeordnet sind, zu regulieren. Besonders bevorzugt kann dabei reguliert werden, hinsichtlich welcher Transporteinheiten der zweiten Transporteinrichtung ein Transport und/oder eine Behandlung synchronisiert wird

Die vorliegende Erfindung ist weiterhin auf ein Verfahren zum Betreiben einer Vorrichtung zum Beschichten von Behältnissen gerichtet, wobei die Behältnisse an einem Einlauf der Vorrichtung übergeben werden und an einem Auslauf die Vorrichtung verlassen, wobei die Behältnisse von einer ersten Transporteinrichtung zumindest mittelbar wenigstens einer Behandlungsstation zugeführt werden können, wobei in der Behandlungsstation mittels einer Vakuumerzeugungseinrichtung ein Vakuum erzeugt wird und die Behältnisse in der Behandlungsstation mit einem Plasma beschichtet werden.

Erfindungsgemäß kann die erste Transporteinrichtung wenigstens zeitweise abgeschaltet werden und die Behältnisse werden von einer zweiten Transporteinrichtung, bei der es sich um eine wenigstens abschnittsweise lineare Transporteinrichtung handelt, vom Einlauf zum Auslauf transportiert, ohne einer Behandlungsstation zugeführt zu werden.

Dabei ist die beschriebene Vorrichtung insbesondere dazu eingerichtet und dafür vorgesehen, dieses beschriebene Verfahren durchzuführen, d.h. dass alle für die obig beschriebene Vorrichtung ausgeführten Merkmale ebenso für das hier beschriebene Verfahren offenbart sind und umgekehrt.

Bei einem vorteilhaften Verfahren werden die Behältnisse in der zweiten Transporteinrichtung von einer aufrechtstehenden Position in eine umgedrehte Position gewendet und/oder von einer umgedrehten Position in eine aufrechtstehende Position.

Bei einem vorteilhaften Verfahren werden die Behältnisse an einem Übergabepunkt der der zweiten Transporteinrichtung an die erste Transporteinrichtung übergeben und an dem im Wesentlichen gleichen Übergabepunkt von der ersten Transporteinrichtung zu der zweiten Transporteinrichtung.

Bei einem bevorzugten Verfahren werden die Behältnisse zunächst von der zweiten Transporteinrichtung transportiert. Vorteilhaft werden sie während dieses Transports von einer aufrechtstehenden Position in eine umgedrehte Position gewendet. Während eines Produktionsbetriebs, bei dem Behältnisse beschichtet werden sollen, werden die Behältnisse anschließend vorteilhaft von der zweiten Transporteinrichtung an die erste Transporteinrichtung übergeben. Dabei befinden sich die Behältnisse bevorzugt in einer umgedrehten Position. Von der ersten Transporteinrichtung werden die Behältnisse zumindest mittelbar den Behandlungsstationen zugeführt, in denen die Behältnisse beschichtet werden. Anschließend werden die beschichteten Behältnisse bevorzugt von der ersten Transporteinrichtung an die zweite Transporteinrichtung am Übergabepunkt übergeben. Die beschichteten Behältnisse werden vorteilhaft von der zweiten Transporteinrichtung weitertransportiert. Vorteilhaft werden die beschichteten Behältnisse während des Weitertransports auf der zweiten Transporteinrichtung von einer umgedrehten in eine aufrechtstehende Position gewendet.

Bei einem vorteilhaften Verfahren übernimmt eine Handhabungsvorrichtung in einem Übergabebereich eine vordefinierte Anzahl von Behältnissen von der ersten Transporteinrichtung, bewegt sie auf einem Transportpfad und gibt sie in einem Abgabebereich an die erste Transporteinrichtung ab, wobei wenigstens eine weitere Handhabungsvorrichtung in einem weiteren Übergabebereich eine vordefinierte Anzahl von Behältnissen von der ersten Transporteinrichtung übernimmt, auf einem Transportpfad bewegt und in einem weiteren Abgabebereich an die erste Transporteinrichtung abgibt, wobei die Handhabungsvorrichtungen die Behältnisse auf dem Transportpfad jeweils zu wenigstens einer der Handhabungsvorrichtung zugeordneten Behandlungsstation transportiert.

Ein bevorzugter Ablauf sieht beispielsweise folgendermaßen aus: Die Handhabungsvorrichtung befindet sich zu Beginn in einer Ruheposition. Sobald sich die von ihr zu behandelnden Behältnisse auf der Transporteinrichtung nähern, startet die Bewegung der Handhabungsvorrichtung. Vorteilhaft handelt es sich dabei um eine Rotationsbewegung. Die Handhabungsvorrichtung nimmt eine definierte Anzahl von Behältnissen von der Transporteinrichtung und beendet die Rotation bei den Behandlungsstationen. Vorteilhaft werden die Behältnisse exakt so weit bewegt, dass jedes Behältnis einer Behandlungsstation zugeordnet ist. Unter dem Begriff "zugeordnet" ist dabei zu verstehen, dass sich das Behältnis in unmittelbarer räumlicher Nähe zu einer Behandlungsstation befindet, also beispielsweise direkt darüber, darunter oder daneben. Vorteilhaft führt die Handhabungsvorrichtung die Behältnisse in die Behandlungsstationen ein und/oder die Behandlungsstationen übernehmen die Behältnisse von der Handhabungsvorrichtung.

Bei einem bevorzugten Verfahren werden die Behältnisse auf der ersten Transporteinrichtung und/oder der zweiten Transporteinrichtung mit konstanter Geschwindigkeit bewegt. Vorteilhaft läuft ein kontinuierlich laufender Behältnisstrom in die Vorrichtung herein und aus ihr heraus, während nur die Behandlung getaktet/stationär stattfindet.

Es ist jedoch auch denkbar, dass die Geschwindigkeit der Transporteinrichtung variiert, z.B. um Lücken im Behältnisstrom auszugleichen oder die Behältnisse in ein bestimmtes Teilungsmuster zu bringen. Ein eventuelles Teilungsmuster kann bevorzugt entweder bereits vor der Vorrichtung, in einem Einlaufstern oder in einer der Transporteinrichtungen, besonders bevorzugt der zweiten Transporteinrichtung erzeugt werden.

Bei einem vorteilhaften Verfahren weist die zweite Transporteinrichtung eine Vielzahl von Transporteinheiten auf, wobei nur jede zweite Transporteinheit ein Behältnis transportiert. Bevorzugt weist die weist die erste Transporteinrichtung eine Vielzahl von Transporteinheiten auf, wobei nur jede zweite Transporteinheit ein Behältnis transportiert. An den Übergabe- bzw. Abgabepunkten zwischen den Handhabungsvorrichtungen und der ersten Transporteinrichtung wird bei der Behältnisübergabe bevorzugt immer abwechselnd ein Behältnis aufgenommen und abgegeben.

Bei einem vorteilhaften Verfahren kann die Handhabungsvorrichtung zusätzlich zur Transportbewegung eine Hubbewegung der Behältnisse durchführen. Bevorzugt beinhaltet eine Handhabungsvorrichtung einen Stern/ein Karussell, das eine Dreh- und Hubbewegung durchführen kann. Beide Bewegungen finden in getakteter Art und Weise statt. Vorteilhaft wird ein Behältnis durch eine Hubbewegung in eine Vakuumkammer der Behandlungsstation eingetaucht, in der der Beschichtungsvorgang ausgeführt wird.

Ein vorteilhaftes Verfahren, bei dem die Behältnisse beschichtet werden sollen, sieht daher beispielsweise folgendermaßen aus: Ein Teilungsverzugsstern nimmt die Behältnisse von einem stromaufwärts angeordneten Transferstern ab und ändert den Teilungsabstand so, dass jede zweite Transporteinheit (zur Unterscheidung als A-Klammer bezeichnet) bestückt wird. Weist die zweite Transporteinrichtung einen Langstator Linearmotor auf, kann auf den Teilungsverzugsstern auch verzichtet werden und der Teilungsabstand wird mithilfe des Langstator Linearmotors verändert. Die Behältnisse werden auf der zweiten Transporteinrichtung gewendet und am Übergabepunkt an die erste Transporteinrichtung übergeben. Die Teilung der ersten und zweiten Transporteinrichtung ist so ausgelegt, dass auch jede zweite Transporteinheit (A-Klammer) der ersten Transporteinrichtung bestückt wird.

Kommt der entsprechende Behältnispulk an die entsprechende Behandlungsstation, werden die Behältnisse von A-Klammern von der Hub-/Dreheinheit abgenommen und in der gleichen Drehbewegung werden die beschichteten Behältnisse auf B-Klammern (die zuvor unbesetzten Transporteinheiten zwischen den A-Klammern) übergeben. Kommen nun die Behältnisse, die sich auf den B-Klammern befinden an den Übergabepunkt, werden die Behältnisse an die zweite Transporteinrichtung auf die B-Klammern übergeben. Die Behältnisse werden auf der zweiten Transporteinrichtung gewendet und dann von einem Teilungsverzugsstern abgenommen und an einen Transferstern übergeben.

Sollen die Behältnisse (zwischenzeitlich) nicht beschichtet werden, beispielsweise weil die Behandlungsstationen gewartet werden sollen bzw. eine bestimmte Behältnissorte keine Beschichtung benötigt, kann vorteilhaft in einen "Bypass-Betrieb" umgeschaltet werden. Hierzu kommen zwei alternative Verfahren in Betracht. Welches Verfahren gewählt wird, hängt von der Ausgestaltung der Vorrichtung ab:
Handelt es sich um eine Vorrichtung, bei der auf der zweiten Transporteinrichtung der Abstand zwischen den einzelnen Transporteinheiten unveränderlich ist, wird bevorzugt ein Verfahren wie das folgende gewählt:
Ein Teilungsverzugsstern nimmt die Behältnisse von einem Transfernstern ab und ändert den Teilungsabstand so, dass jede zweite Transporteinheit (A-Klammer) besetzt ist. Der Übergabepunkt ist nicht aktiv, sodass die Behältnisse nicht an die erste Transporteinrichtung übergeben wird. Die Behältnisse werden ohne eine Beschichtung zu bekommen auf der zweiten Transporteinrichtung weitertransportiert. Von einem Teilungsverzugsstern werden die Behältnisse von den A-Klammer abgenommen. Anders als in einem Beschichtungsmodus befinden sich die Behältnisse somit nicht auf B-Klammern, sondern auf A-Klammern.

Vorteilhaft wird ein der zweiten Transporteinrichtung nachfolgender Produktionsstrom um eine halbe Teilung elektronisch versetzt wird. Als Teilung ist dabei der Abstand zwischen zwei Behältnissen zu verstehen. Vorteilhaft wird ein der zweiten Transporteinrichtung nachfolgender Produktionsstrom um den Abstand zwischen zwei Transporteinheiten elektronisch versetzt. Da bevorzugt jede zweite Transporteinheit besetzt ist, entspricht der Abstand zwischen zwei Transporteinheiten einer halben Teilung. Hierdurch wird sichergestellt, dass die Produktion bei den nachfolgenden Vorrichtungen ohne Probleme weiterlaufen kann, obwohl sich die Behältnisse nicht auf B-Klammern befinden wie in einem Beschichtungsmodus, sondern auf A-Klammern.

Handelt es sich um eine Vorrichtung, bei der auf der zweiten Transporteinrichtung der Abstand zwischen den einzelnen Transporteinheiten veränderlich ist, beispielsweise über einen Langstator Linearmotor, wird bevorzugt ein Verfahren wie das folgende gewählt:
Ein Transferstern übergibt die Behältnisse an Transporteinheiten der zweiten Transporteinrichtung. Dabei wird nur jede zweite Transporteinheit (A-Klammern) der zweiten Transporteinrichtung mit Behältnissen bestückt. Im Beschichtungsmodus würde nun mittels des Langstator Linearmotors der Teilungsverzug so umgesetzt werden, dass die Behältnisse an die erste Transporteinrichtung übergeben werden kann. Im Bypass-Betrieb erfolgt dies nicht und von den A-Klammern werden die Behältnisse an einen Auslaufstern übergeben. D.h. die B-Klammern sind im Bypass-Betrieb nicht bestückt. Da die Bewegung der Transporteinheiten mithilfe des Langstator Linearmotors gesteuert werden kann, können die Transporteinheiten derart gesteuert werden, dass sich im Bypass-Betrieb die (bestückten) A-Klammern bei der Übergabe an den Auslaufstern an der Stelle befinden, an der sich in einem Beschichtungsmodus die (bestückten) B-Klammern befinden würden. Hierdurch kann der Produktionsstrom nach der Vorrichtung zum Beschichten von Behältnissen unverändert bleiben, da sich für diesen keine Änderung zwischen Beschichtungsmodus und Bypass-Betrieb ergibt.

Weitere Vorteile und Ausführungsformen ergeben sich aus den beigefügten Zeichnungen:
Darin zeigen:
- Fig. 1: eine schematische Darstellung einer Anlage mit einer erfindungsgemäßen Vorrichtung;
- Fig. 2: eine schematische Darstellung einer erfindungsgemäßen Vorrichtung;
- Fig. 3: eine weitere schematische Darstellung einer erfindungsgemäßen Vorrichtung;
- Fig. 4: eine schematische Darstellung einer erfindungsgemäßen Vorrichtung mit stromabwärts angeordneten weiteren Behandlungsvorrichtungen;
- Fig. 5: eine Darstellung einer zweiten Transporteinrichtung, die auch eine Wendeeinrichtung ist.

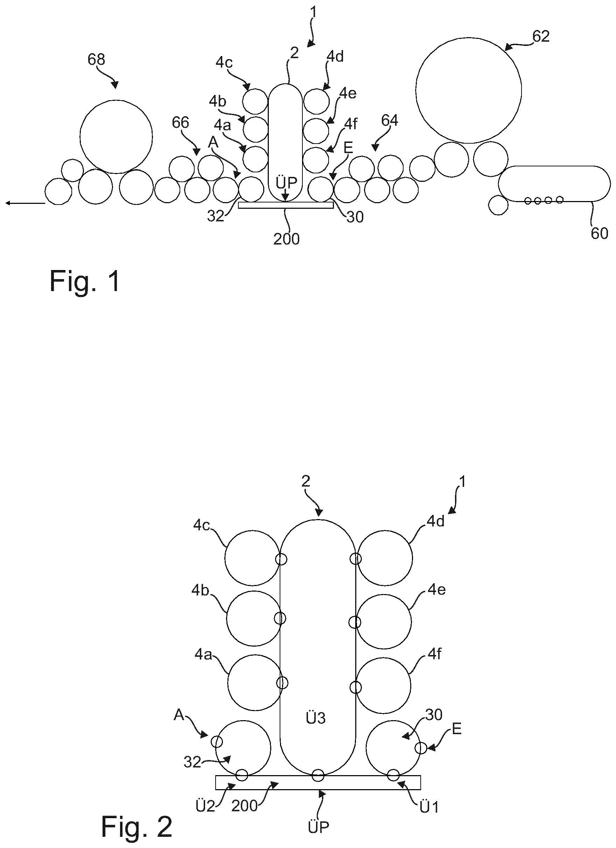

Fig. 1 zeigt eine schematische Darstellung einer Anlage mit einer erfindungsgemäßen Vorrichtung 1. Diese Figur zeigt somit beispielhaft, wie die erfindungsgemäße Vorrichtung 1 in eine Gesamtanlage integriert sein kann. Zu erkennen ist, dass die Behältnisse 10 zunächst als Vorformlinge (nicht gezeigt) eine Heizeinrichtung 60 durchqueren, anschließend eine Umformungseinrichtung 62 durchlaufen und hier beispielsweise zu Flaschen umgeformt werden. Mittels einer Transfereinrichtung 64 können die Behältnisse von der Umformungseinrichtung 62 bis zum Einlauf E der Vorrichtung 1 zum Beschichten von Behältnissen transportiert werden. Am Einlauf E werden die Behältnisse von einem Einlaufstern 30 übernommen. Bei dem Einlaufstern 30 kann es sich um einen Teilungsverzugsstern oder einen gewöhnlichen Transferstern handeln. Vom Einlaufstern 30 werden die Behältnisse 10 an die zweite Transporteinrichtung 200 übergeben.

Im Bypass-Betrieb werden die Behältnisse auf der Transporteinrichtung 200 bis zu einem Auslaufstern 32 weitertransportiert. Bei dem Auslaufstern 32 kann es sich um einen Teilungsverzugsstern oder einen gewöhnlichen Transferstern handeln. Vom Auslaufstern 32 werden die Behältnisse am Auslauf A an eine weitere Transfereinrichtung 66 übergeben und von dieser zu einem stromabwärts befindlichen Füller transportiert.

In einem Beschichtungsmodus werden die Behältnisse am Übergabepunkt ÜP von der zweiten Transporteinrichtung 200 an eine erste Transporteinrichtung 2 übergeben. Entlang der ersten Transporteinrichtung sind in der Figur sechs Handhabungsvorrichtungen 4a, 4b, 4c, 4d, 4e, 4f eingezeichnet. Jede dieser Handhabungsvorrichtungen kann von der ersten Transporteinrichtung 2 Behältnisse entnehmen und diese Behandlungsstationen zuführen, in denen die Behältnisse beschichtet werden.

Fig. 2 zeigt eine schematische Darstellung einer erfindungsgemäßen Vorrichtung 1. In dieser Figur sind Übergabepunkte, an denen Behältnisse von einer Vorrichtung zur nächsten übergeben werden können, jeweils mit einem Punkt markiert. Zu erkennen als erster Übergabepunkt der Einlauf E am Einlaufstern 30. Weiter zu erkennen ist die zweite Transporteinrichtung 200, der vom Einlaufstern 30 an einem weiteren Übergabepunkt Ü1 die Behältnisse übergeben werden. Ü2 markiert den Übergabepunkt, an dem die Behältnisse von der zweiten Transporteinrichtung 200 an den Auslaufstern 32 übergeben werden. A markiert den Auslauf. Mit ÜP ist der Übergabepunkt zwischen der zweiten und ersten Transporteinrichtung gekennzeichnet. Weitere mögliche Übergabepunkte Ü3 sind jeweils zwischen der ersten Transporteinrichtung 2 und den verschiedenen Handhabungsvorrichtungen 4a-4f.

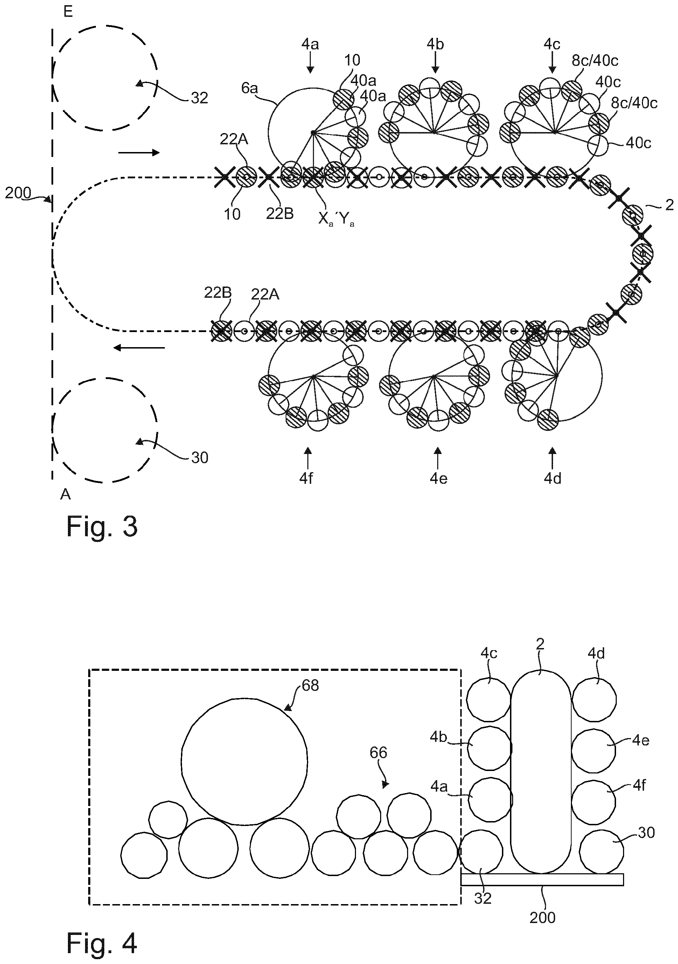

Fig. 3 zeigt eine Darstellung der erfindungsgemäßen Vorrichtung, bei der die Handhabungsvorrichtungen 4a-4f deutlicher dargestellt sind. Es ist zu sehen, dass die erste Transporteinrichtung 2 eine Vielzahl von Transporteinheiten 22 aufweist. Zur Unterscheidung sind die Transporteinheiten abwechselnd mit einem Kreis (22A) oder einem Kreuz (22B) gekennzeichnet. Schraffierte Kreise kennzeichnen ein Behältnis 10.

Um die Transporteinrichtung 2 angeordnet sind mehrere Handhabungsvorrichtungen 4. Für die Handhabungsvorrichtung 4a ist beispielhaft gezeigt, dass der Übergabebereich Xa und der Abgabebereich Ya übereinstimmen. Beispielhaft ist eingezeichnet, dass die Handhabungsvorrichtung 4a einen Träger 6a und mehrere Handhabungseinheiten 40a (Kreise an radialen Linien) aufweist. Diese Handhabungseinheiten 40a sind abwechselnd mit einem Behältnis 10 besetzt (schraffierter Kreis) bzw. unbesetzt (ungefüllter Kreis). Dies ist zur besseren Verdeutlichung auch nochmals bei der Handhabungsvorrichtung 4c eingezeichnet. Hier befindet sich die Handhabungsvorrichtung 40c in einer solchen Position, dass sich unterhalb der mit einem Behältnis 10 besetzten Handhabungsvorrichtungen 40c die Behandlungsstationen 8c (nicht separat gezeigt) befinden.

Während eines Verfahrens, bei dem Behältnisse beschichtet werden sollen, dreht sich beispielsweise die Handhabungsvorrichtung 4a von dieser Position aus im Uhrzeigersinn. Am Abgabepunkt Ya gibt sie zunächst ein behandeltes Behältnis 10 aus der ersten Handhabungseinheit 40a an eine unbesetzte Transporteinheit ab. Nachdem sich sowohl die Handhabungsvorrichtung 4a als auch die Transporteinrichtung 2 synchronisiert weiterbewegt haben, übergibt die Transporteinrichtung 2 aus der hierauf folgenden, besetzten Transporteinheit 22 ein unbehandeltes Behältnis 10 an die zweite (unbesetzte) Handhabungseinheit 40a ab. Die Transporteinrichtung 2 und die Handhabungsvorrichtung 4a drehen sich erneut synchronisiert weiter. Die Handhabungsvorrichtung 4a gibt das nächste behandelte Behältnis aus der dritten Handhabungseinheit 40a an die nächste, unbesetzte Transporteinheit 22 ab, etc. Wie zu erkennen ist, sind deshalb zu Beginn der Transporteinrichtung 2 die Transporteinheiten 22A (mit Kreis markiert) mit einem Behältnis besetzt, während am Ende der Transporteinrichtung die Transporteinheiten 22B (mit Kreuz markiert) mit einem Behältnis besetzt sind. Es ist somit erkennbar, dass die behandelten Behältnisse von den Transporteinheiten 22B transportiert werden, während die unbehandelten Behältnisse von den Transporteinheiten 22A transportiert werden.

Nachdem alle Handhabungseinheiten 40a die behandelten Behältnisse abgegeben haben, bzw. neue unbehandelte Behältnisse aufgenommen haben, dreht sich die Handhabungsvorrichtung 4a bis zu der Position weiter, in der die mit Behältnisse bestückten Handhabungseinheiten 40a über den Behandlungsstationen positioniert sind, damit die Behältnisse 10 in diesen behandelt werden können. In einer entsprechenden Position befindet sich beispielsweise die Handhabungsvorrichtung 40c.

Ebenfalls in Fig. 3 eingezeichnet sind die zweite Transporteinrichtung 200 und der Einlaufstern 30 bzw. Auslaufstern 32. Bei der Transporteinrichtung 200 kann es sich beispielsweise um eine Kette handeln. In diesem Fall wären der Einlaufstern 30 und der Auslaufstern 32 Teilungsverzugssterne. Weist die Transporteinrichtung 200 einen Langstator Linearmotor auf, können der Einlaufstern 30 und der Auslaufstern 32 als gewöhnlicher Transferstern ausgestaltet sein.

Fig. 4 zeigt die bereits beschriebene Vorrichtung zum Beschichten von Behältnissen mit nachgeschalteten Vorrichtungen in Form einer Transfereinrichtung 66 und einem Füller 68. Wie diese betrieben Vorrichtungen 66 und 68 in einem Bypass Betrieb betrieben werden müssen, hängt von der Ausgestaltung der zweiten Transporteinrichtung ab. Weist diese einen Langstator Linearmotor auf, können die Behältnisse in der Transporteinrichtung 200 ausschließlich von Transporteinheiten 22A transportiert werden und die Vorrichtungen 66 und 68 können dennoch genauso betrieben werden wie in einem Beschichtungsmodus. Hier muss lediglich mithilfe des Langstator Linearmotors die Geschwindigkeit der Transporteinheiten so angepasst werden, dass in dem Moment, in dem in einem Beschichtungsmodus eine Transporteinheit 22B am Übergabepunkt Ü2 wäre, nun eine Transporteinheit 22A ist.

Handelt es sich bei der zweiten Transporteinrichtung 200 dagegen um eine Kette, bei der der Abstand zwischen den Transporteinheiten nicht variiert werden kann, müssen die Transfereinrichtung 66 und der Füller 68 (in dem gestrichelten Bereich) über ein elektronisches Getriebe versetzt werden.

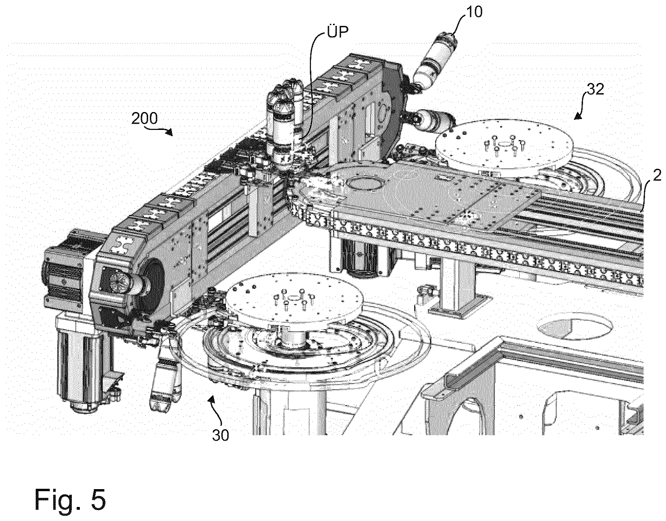

Fig. 5 zeigt eine Darstellung einer zweiten Transporteinrichtung, die auch eine Wendeeinrichtung ist. Zu erkennen ist ein als Teilungsverzugsstern ausgebildeter Einlaufstern 30, der Behältnisse 10 in einer aufrechtstehenden Position an die zweite Transporteinrichtung 200 übergibt. Die Behältnisse werden von der Transporteinrichtung 200 über einen gekrümmten Abschnitt nach oben bewegt. Durch diese Bewegung werden die Behältnisse 10 automatisch gewendet, so dass sie im oberen Bereich der zweiten Transporteinrichtung 200 in einer umgedrehten Position transportiert werden. Am Übergabepunkt ÜP werden die Behältnisse 10 von der zweiten Transporteinrichtung 200 an die erste Transporteinrichtung 2 übergeben. Nachdem die Behältnisse 10 die erste Transporteinrichtung 2 umlaufen haben, werden die Behältnisse 10 wieder am Übergabepunkt ÜP an die zweite Transporteinrichtung 200 übergeben. Die Behältnisse befinden sich dabei noch immer in einer umgedrehten Position, da eine solche Position zum Beschichten bevorzugt ist. Nachdem die Behältnisse einen linearen Abschnitt der Transporteinrichtung 200 entlang transportiert wurden, werden sie einen gekrümmten Abschnitt nach unten transportiert, wodurch die Behältnisse 10 wieder automatisch in eine aufrechtstehende Position gewendet werden. Die Behältnisse 10 werden in dieser aufrechtstehenden Position an den Auslaufstern 32, der als Teilungsverzugsstern ausgestaltet ist, übergeben.

Es wird weiterhin darauf hingewiesen, dass in der einzelnen Figuren auch Merkmale beschrieben wurden, welche für sich genommen vorteilhaft sein können. Der Fachmann erkennt unmittelbar, dass ein bestimmtes in einer Figur beschriebenes Merkmal auch ohne die Übernahme weiterer Merkmale aus dieser Figur vorteilhaft sein kann. Ferner erkennt der Fachmann, dass sich auch Vorteile durch eine Kombination mehrerer in einzelnen oder in unterschiedlichen Figuren gezeigter Merkmale ergeben können.

### Bezugszeichenliste

- 1: Vorrichtung

- 2: erste Transporteinrichtung
- 4(a, b, c, ...): Handhabungsvorrichtung
- 6(a, b, c, ...): beweglicher Träger
- 8(a, b, c, ...): Behandlungsstationen
- 10: Behältnis
- 22 (A, B): Transporteinheit
- 30: Einlaufstern
- 32: Auslaufstern
- 40(a, b, c, ...): Handhabungseinheit
- 60: Heizeinrichtung
- 62: Umformungseinrichtung
- 64: Transfereinrichtung
- 66: Transfereinrichtung
- 68: Füller
- 200: zweite Transporteinrichtung
- 800: Behandlungseinrichtung
- A: Auslauf
- E: Einlauf
- P(a, b, c, ...): Transportpfad
- ÜP: Übergabepunkt
- X(a, b, c, ...): Übergabebereich
- Y(a, b, c, ...): Abgabebereich

## Patentansprüche

1. Vorrichtung (1) zum Beschichten von Behältnissen (10) mit einem Einlauf (E), an dem der Vorrichtung Behältnisse (10) übergeben werden, und einem Auslauf (A), an dem die Behältnisse (10) die Vorrichtung verlassen, mit wenigstens einer Vakuumvorrichtung zur Erzeugung eines Vakuums, mit wenigstens einer Behandlungsstation (8) zum Beschichten von Behältnissen (10) mit einem Plasma, wobei die Behandlungsstation (8) in einer Fluidverbindung mit der Vakuumvorrichtung steht und wobei die Behandlungsstation (8) wenigstens eine Behandlungseinrichtung (800) aufweist, die in ein Behältnis (10) einführbar ist, wobei die Vorrichtung (1) eine erste (2) und eine zweite (200) Transporteinrichtung zum Transportieren von Behältnissen (10) aufweist, wobei die erste Transporteinrichtung (2) die Behältnisse zumindest mittelbar einer Behandlungsstation (8) zuführt,
**dadurch gekennzeichnet, dass**
die erste Transporteinrichtung (2) wenigstens zeitweise abschaltbar ist, so dass die Zuführung von Behältnissen (10) an die Behandlungsstation (8) unterbrochen ist, und es sich bei der zweiten Transporteinrichtung (200) um eine wenigstens abschnittsweise lineare Transporteinrichtung handelt, welche dazu geeignet ist, die Behältnisse (10) auch bei einer abgeschalteten ersten Transporteinrichtung (2) vom Einlauf (E) zum Auslauf (A) zu transportieren, und wobei
die Vorrichtung (1) wenigstens zwei Handhabungsvorrichtungen (4a, 4b) umfasst, zur Übergabe einer vordefinierten Anzahl von Behältnissen (10) von der ersten Transporteinrichtung (2) in einem Übergabebereich (Xa, Xb) und zur Abgabe dieser Behältnisse (10) an die erste Transporteinrichtung (2) in einem Abgabereich (Ya, Yb), wobei jeder Handhabungsvorrichtung mehrere stationäre Behandlungsstationen (8a, 8b) zugewiesen sind, wobei die Handhabungsvorrichtungen (4a, 4b) jeweils einen beweglichen Träger (6a, 6b) aufweisen, mit dem die entnommenen Behältnisse (10) auf einem Transportpfad (Pa, Pb) bewegt werden können, und wobei den Handhabungsvorrichtungen (4a, 4b) jeweils wenigstens eine Behandlungsstation (8a, 8b) zugeordnet ist.

2. Vorrichtung nach Anspruch 1,
**dadurch gekennzeichnet, dass**
die zweite Transporteinrichtung (200) eine Wendeeinrichtung zum Wenden der Behältnisse (10) ist.

3. Vorrichtung nach zumindest einem der vorangegangenen Ansprüche,
**dadurch gekennzeichnet, dass**
die zweite Transporteinrichtung (200) einen Langstator Linearmotor aufweist.

4. Vorrichtung nach zumindest einem der vorangegangenen Ansprüche,
**dadurch gekennzeichnet, dass**
zwischen der ersten (2) und der zweiten (200) Transporteinrichtung ein Übergabepunkt (ÜP) besteht, an dem Behältnisse (10) von der ersten (2) an die zweite (200) und/oder von der zweiten (200) an die erste (2) Transporteinrichtung übergebbar sind.

5. Verfahren zum Betreiben einer Vorrichtung (1) zum Beschichten von Behältnissen (10), wobei die Behältnisse (10) an einem Einlauf (E) der Vorrichtung (1) übergeben werden und an einem Auslauf (A) die Vorrichtung (1) verlassen, wobei die Behältnisse (10) von einer ersten Transporteinrichtung (2) zumindest mittelbar wenigstens einer Behandlungsstation (8) zugeführt werden können, wobei in der Behandlungsstation (8) mittels einer Vakuumerzeugungseinrichtung ein Vakuum erzeugt wird und die Behältnisse (10) in der Behandlungsstation (8) mit einem Plasma beschichtet werden,
**dadurch gekennzeichnet, dass**
die erste Transporteinrichtung (2) wenigstens zeitweise abgeschaltet werden kann und die Behältnisse von einer zweiten Transporteinrichtung (200), bei der es sich um eine wenigstens abschnittsweise lineare Transporteinrichtung handelt, vom Einlauf (E) zum Auslauf (A) transportiert werden, ohne einer Behandlungsstation (8) zugeführt zu werden, und wobei
wenigstens zwei Handhabungsvorrichtungen (4a, 4b) zur Übergabe einer vordefinierten Anzahl von Behältnissen (10) von der ersten Transporteinrichtung (2) in einem Übergabebereich (Xa, Xb) und zur Abgabe dieser Behältnisse (10) an die erste Transporteinrichtung (2) in einem Abgabereich (Ya, Yb), vorgesehen sind, und jeder Handhabungsvorrichtung mehrere stationäre Behandlungsstationen (8a, 8b) zugewiesen sind, wobei die Handhabungsvorrichtungen (4a, 4b) jeweils einen beweglichen Träger (6a, 6b) aufweisen, mit dem die entnommenen Behältnisse (10) auf einem Transportpfad (Pa, Pb) bewegt werden können, und wobei den Handhabungsvorrichtungen (4a, 4b) jeweils wenigstens eine Behandlungsstation (8a, 8b) zugeordnet ist.

6. Verfahren nach dem vorangegangenen Anspruch,
**dadurch gekennzeichnet, dass**
die Behältnisse (10) in der zweiten Transporteinrichtung (200) von einer aufrechtstehenden Position in eine umgedrehte Position gewendet werden und/oder von einer umgedrehten Position in eine aufrechtstehende Position gewendet werden.

7. Verfahren nach wenigstens einem der Ansprüche 5-6,
**dadurch gekennzeichnet, dass**
eine Handhabungsvorrichtung (4a) in einem Übergabebereich (Xa) eine vordefinierte Anzahl von Behältnissen (10) von der ersten Transporteinrichtung (2) übernimmt, auf einem Transportpfad (Pa) bewegt und in einem Abgabebereich (Ya) an die erste Transporteinrichtung (2) abgibt, wobei wenigstens eine weitere Handhabungsvorrichtung (4b) in einem weiteren Übergabebereich (Xb) eine vordefinierte Anzahl von Behältnissen (10) von der ersten Transporteinrichtung (2) übernimmt, auf einem Transportpfad (Pb) bewegt und in einem weiteren Abgabebereich (Yb) an die erste Transporteinrichtung (2) abgibt, wobei die Handhabungsvorrichtungen (4a, 4b), die Behältnisse (10) auf dem Transportpfad (Pa, Pb) jeweils zu wenigstens einer der Handhabungsvorrichtung (4a, 4b) zugeordneten Behandlungsstation (8a, 8b) transportiert.

8. Verfahren nach wenigstens einem der Ansprüche 5-7,
**dadurch gekennzeichnet, dass**
die zweite Transporteinrichtung (200) eine Vielzahl von Transporteinheiten (22) aufweist und nur jede zweite Transporteinheit (22) ein Behältnis (10) transportiert.

9. Verfahren nach wenigstens einem der Ansprüche 5-8,
**dadurch gekennzeichnet, dass**
ein der zweiten Transporteinrichtung (200) nachfolgender Produktionsstrom um eine halbe Teilung elektronisch versetzt wird.

## Claims

1. Apparatus (1) for coating containers (10) having an inlet (E), where containers (10) are handed over to the apparatus, and an outlet (A), where the containers (10) leave the apparatus having at least one vacuum device for producing a vacuum having at least one treatment station (8) for coating containers (10) with a plasma, wherein the treatment station (8) is in fluid connection with the vacuum device and wherein the treatment station (8) has at least one treatment device (800) which is able to be introduced into a container (10), wherein the apparatus (1) has a first (2) and a second (200) transport device for transporting containers (10), wherein the first transport device (2) feeds the containers at least indirectly to a treatment station (8),
**characterized in that**
the first transport device (2) is at least temporarily able to be switched off resulting in the feeding of containers (10) to the treatment stations (8) being interrupted, and the second transport device (200) is an at least sectionally linear transport device, which is suitable to transport the containers (10) from the inlet (E) to the outlet (A) also while a first transport device (2) is switched off, and wherein
the apparatus (1) comprises at least two handling devices (4a, 4b) for handing over a predefined number of containers (10) from the first transport device (2) in a handover area (Xa, Xb) and for submitting these containers (10) to the first transport device (2) in a submission area (Ya, Yb), wherein several stationary treatment stations (8a, 8b) are assigned to each handling device, wherein the handling devices (4a, 4b) respectively have a moveable carrier (6a, 6b) by way of which the containers (10) being removed are able to be moved on a transport path (Pa, Pb), and wherein at least one treatment station (8a, 8b) respectively is assigned to the handling devices (4a, 4b).

2. Apparatus according to claim 1,
**characterized in that**
the second transport device (200) is a turning device for turning the containers (10).

3. Apparatus (1) according to at least one of the preceding claims,
**characterized in that**
the second transport device (200) has a long-stator linear motor.

4. Apparatus according to at least one of the preceding claims,
**characterized in that**
there is a handover point (ÜP) between the first (2) and the second (200) transport device where the containers (10) are able to be handed over from the first (2) to the second (200) and/or from the second (200) to the first (2) transport device.

5. Method for operating an apparatus (1) for coating containers (10), wherein the containers (10) are handed over to an inlet (E) of the apparatus (1) and leave the apparatus (1) at an outlet (A), wherein the containers (10) are able to be fed by a first transport device (2) at least indirectly to at least one treatment station (8), wherein a vacuum is produced within the treatment station (8) by means of a vacuum generation device and the containers (10) are coated with a plasma in the treatment station (8),
**characterized in that**
the first transport device (2) is able to be switched off at least temporarily and the containers are transported by a second transport device (200) which is an at least sectionally linear transport device, from inlet (E) to outlet (A) without being fed to a treatment station (8) and wherein
the apparatus (1) comprises at least two handling devices (4a, 4b) for handing over a predefined number of containers (10) from the first transport device (2) in a handover area (Xa, Xb) and for submitting these containers (10) to the first transport device (2) in a submission area (Ya, Yb), wherein several stationary treatment stations (8a, 8b) are assigned to each handling device, wherein the handling devices (4a, 4b) respectively have a moveable carrier (6a, 6b) by way of which the containers being removed (10) are able to be moved on a transport path (Pa, Pb), and wherein at least one treatment station (8a, 8b) respectively is assigned to the handling devices (4a, 4b).

6. Method according to the preceding claim,
**characterized in that**
the containers (10) are turned in the second transport device (200) from an upright position into a turned position and/or from a turned position into an upright position.

7. Method according to at least one of the claims 5-6,
**characterized in that**
a handling device (4a) takes a predefined number of containers (10) in a handover area (Xa) from the first transport device (2), moves them on a transport path (Pa) and submits them to the first transport device (2) in a submission area (Ya), wherein at least one further handling device (4b) receives a predefined number of containers (10) from the first transport device (2) in a further handover region (Xb), moves them on a transport path (Pb) and submits them to the first transport device (2) in a further submission area (Yb), wherein the handling devices (4a, 4b) transports the containers (10) on the transport path (Pa, Pb) to at least one of the treatment stations (8a, 8b) being assigned to the handling device (4a, 4b) respectively.

8. Method according to at least one of the claims 5-7,
**characterized in that**
the second transport device (200) has a plurality of transport units (22) and every second transport unit (22) only transports a container (10).

9. Method according to at least one of the claims 5-8,
**characterized in that**
a production stream following one of the second transport devices (200) is electronically staggered by half a pitch.

## Revendications

1. Dispositif (1) pour revêtir des récipients (10) avec une entrée (E), sur laquelle des récipients (10) sont transférés au dispositif, et une sortie (A), sur laquelle les récipients (10) quittent le dispositif, avec au moins un dispositif de mise sous vide pour générer un vide, avec au moins une station de traitement (8) pour revêtir des récipients (10) d'un plasma, dans lequel la station de traitement (8) se trouve en communication fluidique avec le dispositif de mise sous vide et dans lequel la station de traitement (8) présente au moins un système de traitement (800), qui peut être introduit dans un récipient (10), dans lequel le dispositif (1) présente un premier (2) et un deuxième système de transport (200) pour transporter des récipients (10), dans lequel le premier système de transport (2) amène les récipients au moins indirectement à une station de traitement (8),
**caractérisé en ce que**
le premier système de transport (2) peut être désactivé au moins par intermittence de sorte que l'amenée de récipients (10) à la station de traitement (8) est interrompue, et le deuxième système de transport (200) est un système de transport au moins par endroits linéaire, lequel est adapté pour transporter les récipients (10) de l'entrée (E) à la sortie (A) également lorsqu'un premier système de transport (2) est désactivé, et dans lequel
le dispositif (1) comprend au moins deux dispositifs de manutention (4a, 4b) pour transférer un nombre prédéfini de récipients (10) du premier système de transport (2) dans une zone de transfert (Xa, Xb) et pour distribuer lesdits récipients (10) au premier système de transport (2) dans une zone de distribution (Ya, Yb), dans lequel plusieurs stations de traitement (8a, 8b) stationnaires sont affectées à chaque dispositif de manutention, dans lequel les dispositifs de manutention (4a, 4b) présentent respectivement un support mobile (6a, 6b), avec lequel les récipients (10) prélevés peuvent être déplacés sur une voie de transport (Pa, Pb), et dans lequel respectivement au moins une station de traitement (8a, 8b) est associée aux dispositifs de manutention (4a, 4b).

2. Dispositif selon la revendication 1,
**caractérisé en ce que**
le deuxième système de transport (200) est un système de retournement destiné à retourner les récipients (10).

3. Dispositif selon au moins l'une quelconque des revendications précédentes,
**caractérisé en ce que**
le deuxième système de transport (200) présente un moteur linéaire à stator longitudinal.

4. Dispositif selon au moins l'une quelconque des revendications précédentes,
**caractérisé en ce que**
il existe entre le premier (2) et le deuxième système de transport (200) un point de transfert (ÜP), sur lequel des récipients (10) peuvent être transférés depuis le premier (2) au deuxième système de transport (200) et/ou depuis le deuxième (200) au premier système de transport (2).

5. Procédé pour faire fonctionner un dispositif (1) pour revêtir des récipients (10), dans lequel les récipients (10) sont transférés à une entrée (E) du dispositif (1) et quittent le dispositif (1) sur une sortie (A), dans lequel les récipients (10) peuvent être amenés par un premier système de transport (2) au moins indirectement à au moins une station de traitement (8), dans lequel un vide est généré dans la station de traitement (8) au moyen d'un système de production de vide et les récipients (10) sont revêtus d'un plasma dans la station de traitement (8),
**caractérisé en ce que**
le premier système de transport (2) peut être désactivé au moins par intermittence et les récipients sont transportés par un deuxième système de transport (200), qui est un système de transport au moins par endroits linéaire, de l'entrée (E) à la sortie (A) sans être amenés à une station de traitement (8), et dans lequel
au moins deux dispositifs de manutention (4a, 4b) sont prévus pour transférer un nombre prédéfini de récipients (10) depuis le premier système de transport (2) dans une zone de transfert (Xa, Xb) et pour distribuer lesdits récipients (10) au premier système de transport (2) dans une zone de distribution (Ya, Yb), et plusieurs stations de traitement (8a, 8b) stationnaires sont affectées à chaque dispositif de manutention, dans lequel les dispositifs de manutention (4a, 4b) présentent respectivement un support (6a, 6b) mobile, avec lequel les récipients (10) prélevés peuvent être déplacés sur une voie de transport (Pa, Pb), et dans lequel respectivement au moins une station de traitement (8a, 8b) est associée aux dispositifs de manutention (4a, 4b).

6. Procédé selon la revendication précédente,
**caractérisé en ce que**
les récipients (10) sont retournés dans le deuxième système de transport (200) depuis une position verticale dans une position renversée et/ou depuis une position renversée dans une position verticale.

7. Procédé selon au moins l'une quelconque des revendications 5-6,
**caractérisé en ce que**
un dispositif de manutention (4a) prend en charge dans une zone de transfert (Xa) un nombre prédéfini de récipients (10) provenant du premier système de transport (2), les déplace sur une voie de transport (Pa) et les distribue au premier système de transport (2) dans une zone de distribution (Ya), dans lequel au moins un autre dispositif de manutention (4b) prend en charge dans une autre zone de transfert (Xb) un nombre prédéfini de récipients (10) provenant du premier système de transport (2), les déplace sur une voie de transport (Pb) et les distribue au premier système de transport (2) dans une autre zone de distribution (Yb), dans lequel les dispositifs de manutention (4a, 4b) transportent les récipients (10) sur la voie de transport (Pa, Pb) respectivement vers au moins une station de traitement (8a, 8b) associée au dispositif de manutention (4a, 4b).

8. Procédé selon au moins l'une quelconque des revendications 5-7,
**caractérisé en ce que**
le deuxième système de transport (200) présente une pluralité d'unités de transport (22) et seulement une unité de transport (22) sur deux transporte un récipient (10).

9. Procédé selon au moins l'une quelconque des revendications 5-8,
**caractérisé en ce que**
un flux de production suivant le deuxième système de transport (200) est décalé de manière électronique d'un demi-pas.
